(19)

Europäisches Patentamt

European Patent Office

Office européen des brevets

(11) **EP 4 202 453 A1**

(12) **EUROPEAN PATENT APPLICATION**
published in accordance with Art. 153(4) EPC

(43) Date of publication:
**28.06.2023 Bulletin 2023/26**

(21) Application number: **22859567.4**

(22) Date of filing: **01.11.2022**

(51) International Patent Classification (IPC):
**G01R 31/12** (2020.01)  **H01T 2/00** (2006.01)

(86) International application number:
**PCT/CN2022/129101**

(87) International publication number:
**WO 2023/078270 (11.05.2023 Gazette 2023/19)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **03.11.2021 CN 202111295996**

(71) Applicants:
• **State Grid Corporation of China**
  **Beijing 100031 (CN)**
• **State Grid Anhui Electric Power Research Institute**
  **Hefei, Anhui 230601 (CN)**
• **Xi'an Jiaotong University**
  **Xi'an, Shaanxi 710049 (CN)**

(72) Inventors:
• **FU, Zhong**
  **Hefei**
  **Anhui 230601 (CN)**
• **PEI, Zhehao**
  **Xi'an**
  **Shaanxi 710049 (CN)**

• **CHEN, Weijiang**
  **Beijing 100031 (CN)**
• **ZHU, Taiyun**
  **Hefei**
  **Anhui 230601 (CN)**
• **CHEN, Qingtao**
  **Hefei**
  **Anhui 230041 (CN)**
• **WU, Zhengyang**
  **Hefei**
  **Anhui 230601 (CN)**
• **LIU, Jing**
  **Hefei**
  **Anhui 230601 (CN)**
• **LIU, Yushun**
  **Hefei**
  **Anhui 230601 (CN)**
• **LIU, Xiaosong**
  **Xi'an**
  **Shaanxi 710049 (CN)**
• **ZHANG, Qiaogen**
  **Xi'an**
  **Shaanxi 710049 (CN)**

(74) Representative: **Michalski Hüttermann & Partner**
  **Patentanwälte mbB**
  **Kaistraße 16A**
  **40221 Düsseldorf (DE)**

(54) **LASER-INDUCED DISCHARGING METHOD AND SYSTEM FOR GENERATING LONG-RANGE CONTROLLABLE HIGH-VOLTAGE DISCHARGE**

(57)    The present disclosure provides a laser induced discharge system for generating a long-distance controllable high-voltage discharge, including a high-power ultrashort pulse laser source, a guiding optical path, a discharge system, and a control system, where laser is incident on the discharge system after passing through the guiding optical path, a spatial coordination relationship between laser and a discharge is determined by the guiding optical path, and a temporal coordination relationship between the laser source and the discharge system is determined by the control system; the guiding optical path is composed of a plurality reflectors (1, 2, 3, 4) and a convex lens (5), and a distance between the

$$z_f^{'} = \frac{1}{1/f + 1/z_f}, z_f = \frac{0.367 k a_0^2}{\left\{ \left[ \left( P/P_c \right)^{1/2} - 0.852 \right]^2 - 0.0219 \right\}^{1/2}}$$

convex lens (5) and a tip of a rod electrode is
; and the control system obtains a laser signal and starts the discharge module, and the control system is provided with

**EP 4 202 453 A1**

**(Cont. next page)**

a trigger delay $\delta t$, namely, $\delta t = 1\text{ms} - t_d - t_f$. The laser induced discharge system in the present disclosure can generate a meter-level controllable high-voltage discharge along a laser path, has stable trigger and guiding characteristics, and is of great significance for promoting the development of laser induced lightning, long-distance detection, and other fields.

FIG. 1

## Description

## TECHNICAL FIELD

The present disclosure relates to the technical field of high voltage applications, and specifically, to a laser induced discharge method and system for generating a long-distance controllable high-voltage discharge.

## BACKGROUND

As a technology that uses controllability of laser and large energy of a discharge to achieve photoelectric energy coupling, laser induced discharge is widely used in precision machining, high-voltage switch synchronization, and other fields, and has potential application value in laser induced lightning, long-distance detection, and other fields. At present, a nanosecond pulse laser is maturely applied in the field of the laser induced discharge. However, due to characteristics of a long pulse width and high energy of the nanosecond pulse laser, when laser is propagated in an air medium, electron avalanches are generated in air to form breakdown sparks to shield laser at a back edge of a pulse. As a result, a continuous plasma channel cannot be formed. Energy of the laser also attenuates rapidly during the propagation due to air breakdown, which severely limits a length of the plasma channel. As a result, long-distance guiding of a high-voltage discharge cannot be realized, thereby limiting the development of the laser induced discharge in the laser induced lightning, the long-distance detection, and other fields.

For example, a dipulse-based laser induced gap breakdown switching device disclosed in the application with the application number of CN201910001377.1 includes a laser-triggered switching apparatus based on optical fiber control, a signal coupling apparatus, and a control and detection apparatus. The laser-triggered switching apparatus based on optical fiber control includes a box body, a first plano-convex lens, a hollow electrode, a plate electrode, and a first optical fiber connector. The control and detection apparatus includes a dipulse nanosecond laser and a programmable pulse delay generator. The dipulse nanosecond laser generates first pulse laser and main pulse laser, and focuses them on the plate electrode. The programmable pulse delay generator adjusts a time interval of the first pulse laser and the main pulse laser. Weaker first pulse laser enters the box body through an optical fiber focuser and induces generation of an initial plasma. Subsequently, laser energy of the main pulse is high when the main pulse secondarily bombards the plate electrode, inducing generation of a high-temperature and high-density main plasma. This effectively guides a gap breakdown discharge path, so as to avoid switch jitter and a trigger delay during laser triggered gap discharge. The switching device can avoid the switch jitter and the trigger delay to some extent, but it still cannot realize the long-distance guiding of the high-voltage discharge.

In recent years, an ultrashort pulse laser technology has developed rapidly. Compared with a high-energy nanosecond laser used before the ultrashort pulse laser technology, a high-power ultrashort pulse laser produces a nonlinear optical effect during propagation in the medium, overcomes shortcomings such as discontinuity and a short length of a plasma channel of the nanosecond laser by using a dynamic balance between a Kerr self-focusing effect and a plasma defocusing effect, so as to perform ionization in the air to produce a continuous and long plasma channel, thereby having a good application prospect in the fields of guiding the long-distance high-voltage discharge, the long-distance detection, and the like. Based on an ionization and propagation mechanism of the ultrashort pulse laser in the air, the long plasma channel has its unique distribution characteristics of electrical properties in time and space, resulting in different impacts of laser parameters, discharge system parameters, and temporal and spatial coordination between laser generated by a laser system and a discharge generated by a discharge system on trigger and guiding characteristics of the high-voltage discharge. To sum up, a laser induced discharge system with stable trigger and guiding characteristics is needed to generate a long-distance controllable high-voltage discharge and promote a development of the laser induced lightning, the long-distance detection, and other fields.

## SUMMARY

A technical problem to be resolved in the present disclosure is to provide a long-distance controllable high-voltage discharge system with stable trigger and guiding characteristics.

The present disclosure resolves the above problem by using following technical solutions:

A laser induced discharge system for generating a long-distance controllable high-voltage discharge includes a laser system, a guiding optical path, a discharge module, and a control system, where a laser source of the laser system is a high-power ultrashort pulse laser source;

the control system receives a laser signal of the laser system, and starts the discharge module based on the laser signal; and the control system is provided with a trigger delay;

the guiding optical path includes a plurality of reflectors and a convex lens; laser reaches the convex lens after being reflected by the reflectors, and then reaches the discharge module through the convex lens; and a distance between the convex lens and a tip of a rod electrode of the discharge module is calculated according to following formulae:

$$z'_f = \frac{1}{1/f + 1/z_f}$$

$$z_f = \frac{0.367 k a_0^2}{\left\{ \left[ (P/P_c)^{1/2} - 0.852 \right]^2 - 0.0219 \right\}^{1/2}}$$

where $k$ represents a wave number, $a_0$ represents a spot radius, $P$ represents a laser peak power, $P_c$ represents a critical power of the laser when the laser generates ionization and makes laser filament, $f$ represents a focal length of the convex lens, and $z_f$ represents a self-focusing effect of an incident gap of the laser; and
the trigger delay $\delta t$ is equal to 1 ms-$t_d$-$t_f$, where $t_d$ represents time from triggering of a first-level sphere gap of an impulse voltage generator in the discharge module to loading of a switching impulse voltage waveform to the rod electrode, and $t_f$ represents time of a rising edge of the impulse voltage waveform.

The laser induced discharge system in the present disclosure invention can generate a meter-level discharge that is from the tip of the rod electrode and develops along a laser path when the laser reaches the rod electrode, and realize a long-distance controllable high-voltage discharge with controllable start discharge time and a controllable discharge path.

Further, the laser source is an ultrashort pulse laser that is generated based on a titanium doped sapphire gain medium and a chirped pulse amplification technology and has a repetition frequency of 10 Hz, a wavelength of 800 nm, MJ-level energy, and an fs-level or ps-level pulse width.

Further, a geometric focal length of the convex lens is 10 m.

Further, the discharge module includes the impulse voltage generator and the rod electrode, the impulse voltage generator is capable of generating a negative switching impulse voltage with a peak value of equal to or greater than 1.6 MV, a rod-plate gap of the rod electrode is greater than or equal to 2 m, a curvature radius of the tip of the rod electrode is 10 mm, the rod electrode is connected to a high voltage, and a plate electrode is grounded.

Further, the control system includes a photoelectric detector, an oscilloscope, a delay controller, and an electro-optic/photoelectric conversion module, the photoelectric detector is connected to the oscilloscope, the oscilloscope is connected to the delay controller, the delay controller is connected to the electro-optic/photoelectric conversion module, and the electro-optic/photoelectric conversion module is connected to the discharge module.

Correspondingly to the above system, the present disclosure further provides a laser induced discharge method for generating a long-distance controllable high-voltage discharge, including following steps:

step 1: building a discharge system, where the discharge system includes a laser system, a guiding optical path, a discharge module, and a control system; a laser source of the laser system is a high-power ultrashort pulse laser source; the control system receives a laser signal of the laser system, and starts the discharge module based on the laser signal; and the control system is provided with a trigger delay;
the guiding optical path includes a plurality of reflectors and a convex lens; laser reaches the convex lens after being reflected by the reflectors, and then reaches the discharge module through the convex lens; and a distance between the convex lens and a tip of a rod electrode of the discharge module is calculated according to following formulae:

$$z'_f = \frac{1}{1/f + 1/z_f}$$

$$z_f = \frac{0.367 k a_0^2}{\left\{ \left[ (P/P_c)^{1/2} - 0.852 \right]^2 - 0.0219 \right\}^{1/2}}$$

where $k$ represents a wave number, $a_0$ represents a spot radius, $P$ represents a laser peak power, $P_c$ represents a critical power of the laser when the laser generates ionization and makes laser filament, $f$ represents a focal length of the convex lens, and $z_f$ represents a self-focusing effect of an incident gap of the laser; and
the trigger delay $\delta t$ is equal to 1 ms-$t_d$-$t_f$, where $t_d$ represents time from triggering of a first-level sphere gap of an impulse voltage generator in the discharge module to loading of a switching impulse voltage waveform to the rod electrode, and $Z_f$ represents time of a rising edge of the impulse voltage waveform;
step 2: starting the laser source, detecting, by the control system, a first laser output signal of the laser source to form a trigger signal, and transmitting the trigger signal to the impulse voltage generator; and
step 3: triggering, by the impulse voltage generator, a discharge after receiving the trigger signal, where a delay setting of the control system enables a second signal of the laser system to temporally coincide with a voltage pulse loaded on the rod electrode by the impulse voltage generator, such that the discharge develops along a laser path.

Further, the laser source is an ultrashort pulse laser that is generated based on a titanium doped sapphire gain medium and a chirped pulse amplification technology and has a repetition frequency of 10 Hz, a wavelength of 800 nm, MJ-level energy, and an fs-level or ps-level pulse width.

Further, a geometric focal length of the convex lens is 10 m.

Further, the discharge module includes the impulse voltage generator and the rod electrode, the impulse voltage generator is capable of generating a negative switching impulse voltage with a peak value of equal to or greater than 1.6 MV, a rod-plate gap of the rod electrode is greater than or equal to 2 m, a curvature radius of the tip of the rod electrode is 10 mm, the rod electrode is connected to a high voltage, and a plate electrode is grounded.

Further, the control system includes a photoelectric detector, an oscilloscope, a delay controller, and an electro-optic/photoelectric conversion module, the photoelectric detector is connected to the oscilloscope, the oscilloscope is connected to the delay controller, the delay controller is connected to the electro-optic/photoelectric conversion module, and the electro-optic/photoelectric conversion module is connected to the discharge module.

The present disclosure has following advantages:

In the laser induced discharge system of the present disclosure, the high-power ultrashort pulse laser source can perform ionization to form a 5 m long plasma channel in air after passing through the guiding optical path, which is much longer than a plasma channel that can be formed in the air by a nanosecond pulse laser in an existing laser induced discharge system. Based on the distance between the convex lens in the guiding optical path and the tip of the rod electrode, a longest-distance discharge starting from the tip of the rod electrode can be realized, that is, optimal spatial coordination between the laser system and the discharge module is achieved. The delay is set for the delay controller, which achieves optimal temporal coordination between the laser system and the discharge module. Under the optimal spatial and temporal coordination between the two systems, a probability of a laser induced discharge (laser-triggered discharge developing along the laser path) can be equal to or greater than 99%, and a path of the laser induced discharge can reach a meter level, which is of great significance to the development of laser guided long-distance high-voltage discharge, laser induced lightning, long-distance laser detection, and other technologies.

**BRIEF DESCRIPTION OF THE DRAWINGS**

FIG. 1 is a schematic diagram of a laser induced discharge system for generating a long-distance controllable high-voltage discharge according to an embodiment of the present disclosure; and

FIG. 2 shows a typical image of a meter-level high-voltage discharge along a laser path and generated by applying the method in the embodiments of the present disclosure.

**DETAILED DESCRIPTION**

In order to make the objectives, technical solutions, and advantages of embodiments of the present disclosure clearer, the following clearly and completely describes the technical solutions in the embodiments of the present disclosure with reference to the embodiments of the present disclosure. Apparently, the described embodiments are some rather than all of the embodiments. All other embodiments obtained by those of ordinary skill in the art based on the embodiments of the present disclosure without creative efforts shall fall within the protection scope of the present disclosure.

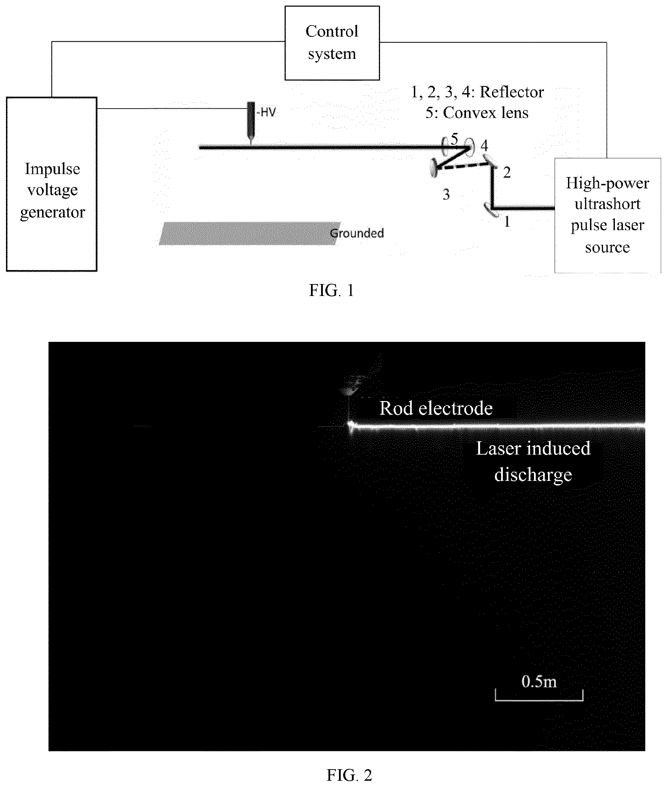

As shown in FIG. 1 and FIG. 2, the embodiments provide a laser induced discharge system for generating a long-distance controllable high-voltage discharge, including a laser source, a guiding optical path, a discharge module, and a control system. The laser source in the embodiments is a high-power ultrashort pulse laser source, namely, an ultrashort pulse laser that is generated based on a titanium doped sapphire gain medium and a chirped pulse amplification technology and has a repetition frequency of 10 Hz, a wavelength of 800 nm, MJ-level energy, and an fs-level or ps-level pulse width. A nonlinear optical effect is generated when high-power ultrashort pulse laser is propagated in a medium, and a continuous long plasma channel can be produced through ionization in air based on a dynamic balance between a Kerr self-focusing effect and a plasma defocusing effect.

The discharge module includes an impulse voltage generator and a rod electrode. The impulse voltage generator is capable of generating a negative switching impulse voltage with a peak value of equal to or greater than 1.6 MV, a rod-plate gap of the rod electrode is greater than or equal to 2 m, a curvature radius of a tip of the rod electrode is 10 mm, the rod electrode is connected to a high voltage, and a plate electrode is grounded.

The guiding optical path includes a plurality of reflectors and a convex lens. laser emitted by the laser source enters the convex lens after being reflected by the reflectors, and then is incident into the discharge module from the convex lens. As shown in FIG. 1, in the embodiments, the horizontally emitted laser is horizontally reflected into the convex lens 5 by using four reflectors 1, 2, 3, and 4 sequentially, and then is incident into the discharge module through the convex lens 5. In the embodiments, a geometric focal length of the convex lens 5 is 10 m.

In the embodiments, the control system includes a photoelectric detector, an oscilloscope, a delay controller, and an electro-optic/photoelectric conversion module. The photoelectric detector is connected to the oscilloscope, the oscilloscope is connected to the delay controller, the delay controller (a DG535 delay controller is adopted in the embodiments) is connected to the electro-optic/photoelectric conversion module, and the electro-optic/photoelectric conversion module is connected to the discharge module. The photoelectric detector detects an output signal of the laser source for the oscilloscope to read. Rising edge trigger is set for the oscilloscope to output a trigger signal to the DG535 delay controller when the signal is read. A delay between the signal output by the oscilloscope and a new trigger signal is set for the DG535 delay controller, and the new trigger signal is transmitted to an electro-optic conversion module of the electro-optic/photoelectric conversion module. After an optical signal is transmitted to a photoelectric conversion module of the electro-optic/photoelectric conversion module by using an optical fiber, a final electrical signal is transmitted to the impulse voltage generator. The trigger delay $\delta t$ is set for the DG535 delay controller, namely, $\delta t = 1\text{ms} - t_d - t_f$, where $t_d$ represents time from triggering of a first-level sphere gap of the impulse voltage generator in the discharge module to loading of a switching impulse voltage waveform to the rod electrode, there are 24 discharge sphere gaps inside the impulse voltage generator, namely, 24 levels of sphere gaps, the first-level sphere gap is a first-level sphere gap among the 24 levels of sphere gaps of the impulse voltage generator, and $t_f$ represents time of a rising edge of the impulse voltage waveform. The electro-optic conversion module is configured to convert a TTL signal into the optical signal, and the photoelectric conversion module is configured to convert the optical signal into a 10 kV pulse signal and trigger the first-level sphere gap of the impulse voltage generator. The laser source is turned on to output the laser at the repetition frequency of 10 Hz. An output first laser signal is detected by the photoelectric detector and becomes a trigger pulse of the first-level sphere gap of the impulse voltage generator after passing through the control system. A delay setting of the control system enables a second signal of a laser system to temporally coincide with a voltage pulse loaded on the rod electrode by the impulse voltage generator, thus generating a laser induced discharge. The guiding optical path guarantees spatial coordination between the laser system and the discharge module, such that the generated laser induced discharge is a long-distance high-voltage discharge along a laser path.

In the embodiments, a distance between a laser emitting end of the guiding optical path and the tip of the rod electrode of the discharge module is calculated according to following formulae:

$$z_f^{'} = \frac{1}{1/f + 1/z_f}$$

$$z_f = \frac{0.367ka_0^2}{\left\{ \left[ \left( P/P_c \right)^{1/2} - 0.852 \right]^2 - 0.0219 \right\}^{1/2}}$$

where $k$ represents a wave number, $a_0$ represents a spot radius, $P$ represents a laser peak power, $P_c$ represents a critical power of the laser when the laser generates ionization and makes laser filament, $f$ represents a focal length of the convex lens, and $z_f$ represents a self-focusing effect of an incident gap of the laser; and

When the focal length of the convex lens is 10 m,

$$z_f^{'} = \frac{1}{1/f + 1/z_f} \approx 8.75\text{m}$$

, is calculated.

That is, the empirical formula gives optimal spatial coordination between the laser system and the discharge module, which can realize a longest-distance discharge starting from the tip of the rod electrode. The trigger delay $\delta t$ is set to $1\text{ms} - t_d - t_f$ for the DG535 delay controller, which achieves optimal temporal coordination between the laser system and the discharge module. Under the optimal spatial and temporal coordination between the two systems, a probability of the laser induced discharge (laser-triggered discharge developing along the laser path) can be equal to or greater than 99%, and a path of the laser induced discharge can reach a meter level, which is of great significance to the development of laser guided long-distance high-voltage discharge, laser induced lightning, long-distance laser detection, and other technologies.

In the embodiments, a combination relationship and a position relationship of the reflectors in the guiding optical path and the geometric focal length of the convex lens are determined based on positions of the laser source and the rod electrode to meet optimal spatial coordination between the laser source and the discharge module, in other words, a distance between the convex lens and the rod electrode. The above spatial distance and delay should meet following conditions: When the first laser signal output by the laser source is detected by the photoelectric detector and becomes the trigger pulse of the first-level sphere gap of the impulse voltage generator after passing through the control system, the delay setting of the control system enables the second signal of the laser system to temporally coincide with the voltage pulse loaded on the rod electrode by the impulse voltage generator, thus generating the laser induced discharge. The guiding optical path guarantees the spatial coordination between the laser system and the discharge module, such that the generated laser induced discharge is the long-distance high-voltage discharge along the laser path.

Based on the above method, the embodiments further provide a laser induced discharge method for generating a long-distance controllable high-voltage discharge, including following steps.

Step 1: Build a discharge system, where the discharge system includes a laser system, a guiding optical path, a discharge module, and a control system; and the laser source reaches the discharge module through the guiding optical path.

The control system includes a photoelectric detector, an oscilloscope, a delay controller, and an electro-optic/photoelectric conversion module. The photoelectric detector is connected to the oscilloscope, the oscilloscope is connected to the delay controller, the delay controller is connected to the electro-optic/photoelectric conversion module, and the electro-optic/photoelectric conversion module is connected to the discharge module.

A distance between a laser emitting end of the guiding optical path and a tip of a rod electrode of the discharge module is calculated according to following formulae:

$$z_f' = \frac{1}{1/f + 1/z_f}$$

$$z_f = \frac{0.367 k a_0^2}{\left\{\left[\left(P/P_c\right)^{1/2} - 0.852\right]^2 - 0.0219\right\}^{1/2}}$$

where $k$ represents a wave number, $a_0$ represents a spot radius, $P$ represents a laser peak power, $P_c$ represents a critical power of the laser when the laser generates ionization and makes laser filament, $f$ represents a focal length of the convex lens, and $z_f$ represents a self-focusing effect of an incident gap of the laser.

A trigger delay $\delta t$ is set for the delay controller, namely, $\delta t = 1$ ms-$t_d$-$t_f$, where $t_d$ represents time from triggering of a first-level sphere gap of an impulse voltage generator in discharge module to loading of a switching impulse voltage waveform to the rod electrode, and $t_f$ represents time of a rising edge of the impulse voltage waveform.

Step 2: Start the laser source, detect, by the photoelectric detector, a first laser output signal of the laser source for the oscilloscope to read, output, by the oscilloscope, a trigger signal to the delay controller when reading the signal, set a delay between the signal output by the oscilloscope and a new trigger signal for the delay controller, and transmit the new trigger signal to an electro-optic conversion module, and transmit a final electrical signal to the impulse voltage generator after an optical signal is transmitted to a photoelectric conversion module by using an optical fiber.

Step 3: Trigger, by the impulse voltage generator, a discharge after receiving the trigger signal, where a delay setting of the control system enables a second signal of a laser system to temporally coincide with a voltage pulse loaded on the rod electrode by the impulse voltage generator, such that the discharge develops along a laser path.

In the embodiments, the laser source is an ultrashort pulse laser that is generated based on a titanium doped sapphire gain medium and a chirped pulse amplification technology and has a repetition frequency of 10 Hz, a wavelength of 800 nm, MJ-level energy, and an fs-level or ps-level pulse width.

The guiding optical path includes a plurality of reflectors and a convex lens. laser emitted by the laser source enters the convex lens after being reflected by the reflectors, and then is incident into the discharge module from the convex lens. A geometric focal length of the convex lens is 10 m.

The discharge module includes the impulse voltage generator and the rod electrode. The impulse voltage generator is capable of generating a negative switching impulse voltage with a peak value of equal to or greater than 1.6 MV, a rod-plate gap of the rod electrode is greater than or equal to 2 m, a curvature radius of a tip of the rod electrode is 10 mm, the rod electrode is connected to a high voltage, and a plate electrode is grounded.

In the embodiments, the photoelectric detector detects the output signal of the laser source for the oscilloscope to read. Rising edge trigger is set for the oscilloscope to output the trigger signal to the DG535 delay controller when the signal is read. The delay between the signal output by the oscilloscope and the new trigger signal is set for the DG535 delay controller, and the new trigger signal is transmitted to the electro-optic conversion module of the electro-optic/photoelectric conversion module. After the optical signal is transmitted to the photoelectric conversion module of the electro-optic/photoelectric conversion module by using the optical fiber, the final electrical signal is transmitted to the impulse voltage generator. The trigger delay $\delta t$ is set for the DG535 delay controller, namely, $\delta t = 1$ ms-$t_d$-$t_f$, where $t_d$ represents the time from triggering of the first-level sphere gap of the impulse voltage generator in the discharge module to loading of the switching impulse voltage waveform to the rod electrode, and $t_f$ represents the time of the rising edge of the impulse voltage waveform. The electro-optic conversion module is configured to convert a TTL signal into the optical signal, and the photoelectric conversion module is configured to convert the optical signal into a 10 kV pulse signal and trigger the first-level sphere gap of the impulse voltage generator. The laser source is turned on to output the laser at the repetition frequency of 10 Hz. An output first laser signal is detected by the photoelectric detector and becomes a trigger pulse of the first-level sphere gap of the impulse voltage generator after passing through the control system. The delay setting of the control system enables the second signal of the laser system to temporally coincide with the voltage pulse loaded on the rod electrode by the impulse voltage generator, thus generating a laser induced discharge. The guiding optical path guarantees spatial coordination between the laser system and the discharge module, such that the generated laser induced discharge is a long-distance high-voltage discharge along a laser path.

In the embodiments, a longest-distance discharge starting from the tip of the rod electrode can be realized based on the distance between the laser emitting end of the guiding optical path and the tip of the rod electrode of the discharge module, in other words, the above distance calculation formula gives optimal spatial coordination between the laser system and the discharge module. The trigger delay $\delta t$ is set to $1\text{ms-}t_\text{d}\text{-}t_\text{f}$ for the DG535 delay controller, which achieves optimal temporal coordination between the laser system and the discharge module. Under the optimal spatial and temporal coordination between the two systems, a probability of the laser induced discharge (laser-triggered discharge developing along the laser path) can be equal to or greater than 99%, and a path of the laser induced discharge can reach a meter level, which is of great significance to the development of laser guided long-distance high-voltage discharge, laser induced lightning, long-distance laser detection, and other technologies.

In the embodiments, a combination relationship and a position relationship of the reflectors in the guiding optical path and the geometric focal length of the convex lens are determined based on positions of the laser source and the rod electrode to meet optimal spatial coordination between the laser source and the discharge module, in other words, a distance between an emitting end of the convex lens and the rod electrode. The above spatial distance and delay should meet following conditions: When the first laser signal output by the laser source is detected by the photoelectric detector and becomes the trigger pulse of the first-level sphere gap of the impulse voltage generator after passing through the control system, the delay setting of the control system enables the second signal of the laser system to temporally coincide with the voltage pulse loaded on the rod electrode by the impulse voltage generator, thus generating the laser induced discharge. The guiding optical path guarantees the spatial coordination between the laser system and the discharge module, such that the generated laser induced discharge is the long-distance high-voltage discharge along the laser path.

The foregoing embodiments are only used to explain the technical solutions of the present disclosure, and are not intended to limit the same. Although the present disclosure is described in detail with reference to the foregoing embodiments, those of ordinary skill in the art should understand that they can still modify the technical solutions described in the foregoing embodiments, or make equivalent substitutions on some technical features therein. These modifications or substitutions do not make the essence of the corresponding technical solutions deviate from the spirit and scope of the technical solutions of the embodiments of the present disclosure.

**Claims**

1. A laser induced discharge system for generating a long-distance controllable high-voltage discharge, comprising a laser system, a guiding optical path, a discharge module, and a control system, wherein a laser source of the laser system is a high-power ultrashort pulse laser source;

   the control system receives a laser signal of the laser system, and starts the discharge module based on the laser signal; and the control system is provided with a trigger delay;
   the guiding optical path comprises a plurality of reflectors (1, 2, 3, 4) and a convex lens (5); laser reaches the convex lens (5) after being reflected by the reflectors (1, 2, 3, 4), and then reaches the discharge module through the convex lens (5); and a distance between the convex lens (5) and a tip of a rod electrode of the discharge module is calculated according to following formulae:

$$z_f^{'} = \frac{1}{1/f + 1/z_f}$$

$$z_f = \frac{0.367 k a_0^2}{\left\{ \left[ \left( P/P_\text{c} \right)^{1/2} - 0.852 \right]^2 - 0.0219 \right\}^{1/2}}$$

   wherein $k$ represents a wave number, $a_0$ represents a spot radius, $P$ represents a laser peak power, $P_\text{c}$ represents a critical power of the laser when the laser generats ionization and makes laser filament, $f$ represents a focal length of the convex lens (5), and $z_f$ represents a self-focusing effect of an incident gap of the laser; and the trigger delay $\delta t$ is equal to $1 \text{ ms-}t_\text{d}\text{-}t_\text{f}$, wherein $t_\text{d}$ represents time from triggering of a first-level sphere gap of an impulse voltage generator in the discharge module to loading of a switching impulse voltage waveform to the rod electrode, and $t_\text{f}$ represents time of a rising edge of the impulse voltage waveform.

2. The laser induced discharge system for generating a long-distance controllable high-voltage discharge according to claim 1, wherein the laser source is an ultrashort pulse laser that is generated based on a titanium doped sapphire gain medium and a chirped pulse amplification technology and has a repetition frequency of 10 Hz, a wavelength of 800 nm, MJ-level energy, and an fs-level or ps-level pulse width.

3. The laser induced discharge system for generating a long-distance controllable high-voltage discharge according to claim 1 or 2, wherein a geometric focal length of the convex lens (5) is 10 m.

4. The laser induced discharge system for generating a long-distance controllable high-voltage discharge according to claim 1 or 2, wherein the discharge module comprises the impulse voltage generator and the rod electrode, the impulse voltage generator is capable of generating a negative switching impulse voltage with a peak value of equal to or greater than 1.6 MV, a rod-plate gap of the rod electrode is greater than or equal to 2 m, a curvature radius of the tip of the rod electrode is 10 mm, the rod electrode is connected to a high voltage, and a plate electrode is grounded.

5. The laser induced discharge system for generating a long-distance controllable high-voltage discharge according to claim 1 or 2, wherein the control system comprises a photoelectric detector, an oscilloscope, a delay controller, and an electro-optic/photoelectric conversion module, the photoelectric detector is connected to the oscilloscope, the oscilloscope is connected to the delay controller, the delay controller is connected to the electro-optic/photoelectric conversion module, and the electro-optic/photoelectric conversion module is connected to the discharge module.

6. A laser induced discharge method for generating a long-distance controllable high-voltage discharge, comprising following steps:

step 1: building a discharge system, wherein the discharge system comprises a laser system, a guiding optical path, a discharge module, and a control system; a laser source of the laser system is a high-power ultrashort pulse laser source; the control system receives a laser signal of the laser system, and starts the discharge module based on the laser signal; and the control system is provided with a trigger delay; the guiding optical path comprises a plurality of reflectors (1, 2, 3, 4) and a convex lens (5); laser reaches the convex lens (5) after being reflected by the reflectors (1, 2, 3, 4), and then reaches the discharge module through the convex lens (5); and a distance between the convex lens (5) and a tip of a rod electrode of the discharge module is calculated according to following formulae:

$$z'_f = \frac{1}{1/f + 1/z_f}$$

$$z_f = \frac{0.367ka_0^2}{\left\{\left[(P/P_c)^{1/2} - 0.852\right]^2 - 0.0219\right\}^{1/2}}$$

wherein $k$ represents a wave number, $a_0$ represents a spot radius, $P$ represents a laser peak power, $P_c$ represents a critical power of the laser when the laser generates ionization and makes laser filament, $f$ represents a focal length of the convex lens (5), and $z_f$ represents a self-focusing effect of an incident gap of the laser; and the trigger delay $\delta t$ is equal to 1 ms-$t_d$-$t_f$, wherein $t_d$ represents time from triggering of a first-level sphere gap of an impulse voltage generator in the discharge module to loading of a switching impulse voltage waveform to the rod electrode, and $t_f$ represents time of a rising edge of the impulse voltage waveform;

step 2: starting the laser source, detecting, by the control system, a first laser output signal of the laser source to form a trigger signal, and transmitting the trigger signal to the impulse voltage generator; and

step 3: triggering, by the impulse voltage generator, a discharge after receiving the trigger signal, wherein a delay setting of the control system enables a second signal of the laser system to temporally coincide with a voltage pulse loaded on the rod electrode by the impulse voltage generator, such that the discharge develops along a laser path.

7. The laser induced discharge method for generating a long-distance controllable high-voltage discharge according to claim 6, wherein the laser source is an ultrashort pulse laser that is generated based on a titanium doped sapphire gain medium and a chirped pulse amplification technology and has a repetition frequency of 10 Hz, a wavelength of 800 nm, MJ-level energy, and an fs-level or ps-level pulse width.

8. The laser induced discharge method for generating a long-distance controllable high-voltage discharge according to claim 6 or 7, wherein a geometric focal length of the convex lens (5) is 10 m.

9. The laser induced discharge method for generating a long-distance controllable high-voltage discharge according to claim 6 or 7, wherein the discharge module comprises the impulse voltage generator and the rod electrode, the impulse voltage generator is capable of generating a negative switching impulse voltage with a peak value of equal to or greater than 1.6 MV, a rod-plate gap of the rod electrode is greater than or equal to 2 m, a curvature radius of the tip of the rod electrode is 10 mm, the rod electrode is connected to a high voltage, and a plate electrode is grounded.

10. The laser induced discharge method for generating a long-distance controllable high-voltage discharge according to claim 6 or 7, wherein the control system comprises a photoelectric detector, an oscilloscope, a delay controller, and an electro-optic/photoelectric conversion module, the photoelectric detector is connected to the oscilloscope, the oscilloscope is connected to the delay controller, the delay controller is connected to the electro-optic/photoelectric conversion module, and the electro-optic/photoelectric conversion module is connected to the discharge module.

1, 2, 3, 4: Reflector
5: Convex lens

FIG. 1

FIG. 2

| INTERNATIONAL SEARCH REPORT | International application No. |
|---|---|
| | **PCT/CN2022/129101** |

**A. CLASSIFICATION OF SUBJECT MATTER**

G01R 31/12(2006.01)n; H01T 2/00(2006.01)i

According to International Patent Classification (IPC) or to both national classification and IPC

**B. FIELDS SEARCHED**

Minimum documentation searched (classification system followed by classification symbols)

G01R; H01T

Documentation searched other than minimum documentation to the extent that such documents are included in the fields searched

Electronic data base consulted during the international search (name of data base and, where practicable, search terms used)

CNTXT, CNKI, ENTXTC, ENTXT, VEN, IEEE: 反光镜, 球隙, 激光, 延时, 时延, 上升沿, 冲击电压, 棒电极, 诱导放电, 等离子通道, mirror, ball gap, laser, delay, latency, rising edge, shock voltage, induced discharge, plasma channel, rod electrode

**C. DOCUMENTS CONSIDERED TO BE RELEVANT**

| Category* | Citation of document, with indication, where appropriate, of the relevant passages | Relevant to claim No. |
|---|---|---|
| PX | CN 114019326 A (ELECTRIC POWER SCIENCE RESEARCH INSTITUTE OF STATE GRID ANHUI ELECTRIC POWER CO., LTD. et al.) 08 February 2022 (2022-02-08) claims 1-10 | 1-10 |
| Y | 张云刚 等 (ZHANG, Yungang et al.). "飞秒激光引导高压放电下的SF6 等离子体时间分辨光谱特性 (Time-resolved Spectral Characteristics of SF6 Plasma under Femtosecond Laser-guided High-voltage Discharge)" 物理学报 (Acta Physica Sinica), Vol. 69, No. 18, 31 December 2020 (2020-12-31), ISSN: 1000-3290, pp. 2-3, and figure 1 | 1-10 |
| Y | 刘洋 等 (LIU, Yang et al.). "飞秒激光等离子体通道电磁波传输研究进展 (Research on the EMP Transmission Performance along the Plasma Channel Induced by the Femtosecond Laser)" 激光与光电子学进展 (Laser & Optoelectronics Progress), Vol. 56, No. 9, 31 May 2019 (2019-05-31), ISSN: 1006-4125, p. 2 | 1-10 |
| Y | CN 109888613 A (GUANGZHOU POWER SUPPLY CO., LTD.) 14 June 2019 (2019-06-14) description, paragraph 42 | 1-10 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **29 December 2022** | **20 January 2023** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

International application No.

**PCT/CN2022/129101**

**C.    DOCUMENTS CONSIDERED TO BE RELEVANT**

| Category* | Citation of document, with indication, where appropriate, of the relevant passages | Relevant to claim No. |
|---|---|---|
| A | CN 113125906 A (ELECTRIC POWER SCIENCE RESEARCH INSTITUTE OF STATE GRID ANHUI ELECTRIC POWER CO., LTD. et al.) 16 July 2021 (2021-07-16)<br>entire document | 1-10 |
| A | CN 208221007 U (NATIONAL UNIVERSITY OF DEFENSE TECHNOLOGY OF PLA) 11 December 2018 (2018-12-11)<br>entire document | 1-10 |
| A | CN 113533918 A (NORTH CHINA ELECTRIC POWER UNIVERSITY (BAODING)) 22 October 2021 (2021-10-22)<br>entire document | 1-10 |
| A | JP 2000133408 A (TOSHIBA CORP., et al.) 12 May 2000 (2000-05-12)<br>entire document | 1-10 |

Form PCT/ISA/210 (second sheet) (January 2015)

**INTERNATIONAL SEARCH REPORT**
Information on patent family members

International application No.

**PCT/CN2022/129101**

| Patent document cited in search report | | | Publication date (day/month/year) | Patent family member(s) | | | Publication date (day/month/year) |
|---|---|---|---|---|---|---|---|
| CN | 114019326 | A | 08 February 2022 | None | | | |
| CN | 109888613 | A | 14 June 2019 | None | | | |
| CN | 113125906 | A | 16 July 2021 | CN | 215375642 | U | 31 December 2021 |
| CN | 208221007 | U | 11 December 2018 | None | | | |
| CN | 113533918 | A | 22 October 2021 | None | | | |
| JP | 2000133408 | A | 12 May 2000 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201910001377